# EUROPEAN PATENT APPLICATION

(11) **EP 3 767 308 A1**
(43) Date of publication of application: **20.01.2021**
(21) Application number: 19186234.1
(22) Date of filing: 15.07.2019
(51) Int. Cl.: G01Q 70/18, B29C 33/42, G01Q 70/06, B29C 33/38, H01L 21/687, G03F 7/20

(54) **A WAFER SUITABLE FOR RECONDITIONING A SUPPORT SURFACE OF A WAFER HOLDING STAGE**

(71) Applicant: Imec VZW, 3001 Leuven (BE)
(72) Inventor: Hantschel, Thomas, 3001 Leuven (BE)
(74) Representative: Patent Department IMEC

(57) **Abstract**

The invention is related to a reconditioning wafer (1) comprising a carrier substrate (2) that supports at least one array of regularly spaced protrusions (3,5,6,7+8) suitable for forming indentations in a support surface of a wafer holding stage. The protrusions within the same array have essentially the same shape and the same dimensions, thereby enabling a more reliable reconditioning process compared to prior art solutions. The protrusions may have the form of pyramids (3) or pillars (6) or other similar shapes with at least the tip of the protrusions formed of a material suitable for making the indentations. The reconditioning wafer is obtainable by a molding technique wherein an array of molds (11) is created in a mold substrate (10), after which the molds are filled with an indentation material such as diamond, and bonded to the carrier substrate (2), after which the mold substrate is removed by thinning and wet etching.

## Description

### Field of the Invention

The present invention is related to the reconditioning of a holding stage used for holding semiconductor wafers in a semiconductor manufacturing or treatment tool.

### State of the art.

A semiconductor wafer holding stage is present in various manufacturing and treatment tools used in the semiconductor industry. A known holding stage used for example in lithography tools, or so-called steppers, comprises a wafer table having at least the size of a standard wafer, and provided with pillar-shaped protrusions of equal height distributed across the holding surface in a regular array. The pillars may have a diameter in the order of 200 micrometre and can be arranged in a rectangular array with a pitch of about 1.5 mm. Wafers are supported on the upper surface of the pillars. The pillars are coated with a diamond-like carbon coating (DLC), functioning as an anti-friction coating. The coating is rough in the beginning but gets smoother over time, which is unwanted as it leads to higher stickiness of the processed or treated wafers.

The DLC coating can be reconditioned by creating nano-sized indentations in the upper surface, i.e. the wafer-supporting surface, of the pillars. This can be realized by a reconditioning wafer which may be a silicon wafer provided with a microcrystalline diamond (MCD) coating. The MCD coating is formed of sharp nano-crystals distributed across the surface of the wafer. With the MCD coating in contact with the carrying surface, a pressure may be exerted on the reconditioning wafer, thereby pushing the sharp nano-crystals into the DLC coating to thereby increase its roughness.

This solution is however not ideal, due to the irregularity of the height and sharpness of the nano-crystals of the MCD coating, as well as the irregularity of the distance between adjacent nano-sized peaks within the MCD coating. In addition, diamond coated silicon wafers are typically prone to wafer bowing due to high stress values. Zero-stress and zero-bow is extremely difficult to achieve, and anti-stress coatings have to be used to mitigate the wafer bow to a lower degree.

### Summary of the invention

The invention aims to provide a solution to the above-described technical problems. This is achieved by a reconditioning wafer and by methods for its production, in accordance with the appended claims. The invention is related to a reconditioning wafer comprising a carrier substrate that supports at least one 2-dimensional array of regularly spaced protrusions suitable for forming indentations in a support surface of a wafer holding stage. The protrusions within the same array have essentially the same shape and the same dimensions, thereby enabling a more reliable reconditioning process compared to prior art solutions. The protrusions may have the form of pyramids or pillars or other similar shapes, with at least the tip of the protrusions formed of a material suitable for making the indentations. The reconditioning wafer is obtainable by several possible manufacturing methods, such as by applying a molding technique wherein an array of molds is created in a mold substrate, after which the molds are filled with an indentation material such as diamond, and bonded to the carrier substrate, after which the mold substrate is removed, preferably by thinning and wet etching.

The reconditioning wafer may be produced in such a way that the indentation material is present as a non-continuous layer that does not cover the entire surface of the carrier wafer. For example in the case of a diamond layer formed on a silicon carrier, this is advantageous in terms of diminishing or eliminating the bowing of the wafer.

The invention is in particular related to a reconditioning wafer suitable for making indentations in a wafer support surface of a wafer holding stage in a semiconductor manufacturing or treatment tool, the reconditioning wafer comprising a carrier substrate and on a planar surface of the carrier substrate, at least one 2-dimensional array of regularly spaced protrusions, the protrusions having essentially the same shape and the same dimensions and wherein at least the tip of the protrusions is formed of a material, hereafter referred to as the indentation material, that is suitable for making said indentations. The indentation material is preferably different from the material of the carrier substrate.

According to an embodiment, the indentation material is chosen from the group consisting of undoped diamond, doped diamond, a carbide, an oxide, a nitride, a metal alloy, a metal.

According to an embodiment, a continuous layer of the indentation material conformally covers the entire array of protrusions, including the surface of the carrier substrate in between the protrusions.

Alternatively, the indentation material may be present in the form of a non-continuous layer that is present at least on the tip of the protrusions.

According to an embodiment, the shape of the protrusions is chosen from the group consisting of : a four-sided pyramid, a three-sided pyramid, a truncated pyramid, a cone, a pillar, a pyramid or a cone on top of a pedestal.

According to an embodiment, the protrusions comprise one or more nano-sized tip portions on their outer surface, the tip portions being considerably smaller than the protrusions.

According to an embodiment, a plurality of arrays of protrusions are arranged on the surface of the carrier substrate, and wherein the protrusions of at least one array are different from the protrusions of the other arrays.

The reconditioning wafer of the invention may comprise an additional layer that covers at least an area of the carrier substrate that corresponds to the array of protrusions, wherein the thickness of the additional layer is lower than the height of the protrusions, so that only the tip of the protrusions sticks out from the surface of the additional layer. The additional layer may be formed of a material that is suitable for picking up debris from the support surface of the wafer holding stage.

According to an embodiment, the planar surface of the carrier substrate comprises, in an area apart from the at least one array of protrusions, a layer formed of a material that is suitable for picking up debris from the support surface of the wafer holding stage.

The invention is equally related to a method for producing a reconditioning wafer in accordance with any one of the preceding paragraphs, comprising the steps of :
- Providing a mold substrate,
- By lithography and etching, producing one or more two dimensional arrays of regularly spaced molds in the mold substrate, the molds having essentially the same shape and dimensions, the molds having slanted sidewalls and an apex area,
- Depositing a layer of the indentation material on the mold substrate, thereby at least partially filling or lining the molds with the indentation material, so that the indentation material is deposited at least on the bottom of the molds,
- Bonding the mold substrate to a carrier substrate, by bonding the layer of indentation material or one or more further layers deposited on top of the layer of indentation material to said carrier substrate,
- Removing the mold substrate to reveal the outer surfaces of the protrusions. The removal preferably involves thinning the mold substrate and removing the thinned mold substrate by wet etching.

According to an embodiment of the above method :
- a mask layer comprising nano-sized mask particles is formed on the protrusions, the nano-sized mask particles being deposited in the molds prior to filling the molds, and/or deposited on the protrusions after removing the mold substrate,
- The protrusions are subjected to a plasma etch procedure, wherein the mask layer acts as an etch mask for the etching of the indentation material, and wherein the etch procedure and the etch mask are configured to produce one or more nano-sized tip portions formed of the indentation material, the one or more tip portions being considerably smaller than the protrusions formed after removing the mold substrate.

According to one form of the latter embodiment, the protrusions are pyramid-shaped and at the end of the plasma etch procedure, one or more nano-sized tip portions are present on the apex area of the protrusions and no tip portions are present on the side planes of the protrusions, through one or a combination of the following effects :
- a higher concentration of masking particles is deposited on the apex area than on the side planes, during the plasma etch procedure,
- the protrusions comprise a core and on said core a layer of the indentation material, and the thickness of said layer is higher on the apex area than one the side planes, so that at the end of the plasma etch procedure, the indentation material is removed from the side planes.

An alternative method for producing a reconditioning wafer according to the invention comprises the steps of :
- providing a substrate having a planar upper surface,
- producing a mask layer on the planar upper surface,
- patterning the mask layer to form a regular array of islands of masking material,
- subjecting the substrate to a dry etch process to thereby create cone-shaped or pillar-shaped protrusions in the substrate at the locations of the islands,
- coating at least the upper part of the protrusions with a layer of the indentation material.

Another alternative method for producing a reconditioning wafer according to the invention comprises the steps of :
- providing a first substrate having a planar upper surface,
- depositing a layer of the indentation material on the planar upper surface and thereafter bonding the substrate to a carrier substrate, by bonding the layer of indentation material or one or more further layers deposited on top of the layer of indentation material to said carrier substrate,
- removing the first substrate, to obtain the carrier substrate with the layer of indentation material bonded thereto,
- producing a mask layer on the layer of indentation material and patterning the mask layer to form a regular array of islands of masking material,
- subjecting the layer of indentation material to a dry etch process to thereby create cone-shaped or pillar-shaped protrusions formed of the indentation material at the locations of the islands.

### Brief description of the figures

Figure 1 shows a reconditioning wafer according to one embodiment of the invention, comprising pyramid-shaped diamond-coated protrusions.
Figures 2a to 2g illustrate key steps of a process for manufacturing the wafer shown in Figure 1, using a molding technique.
Figure 3a to c illustrates an alternative embodiment wherein the diamond coating is not continuous across the reconditioning wafer.
Figures 4a and 4b illustrate how molds may be partially filled in the manufacturing process.
Figures 5a and 5b illustrate a second form of partially filled molds used in the manufacturing process.
Figure 6 illustrates the formation of arrays of nano-cones and nano-pillars on a reconditioning wafer according to the invention.
Figure 7 illustrates a protrusion in the form of a pyramid on top of a pedestal.
Figure 8 illustrates an embodiment, wherein an organic layer is present on the reconditioning wafer, with the tips of the protrusions sticking out of the organic layer.
Figures 9a to 9c illustrate an alternative method for producing a reconditioning wafer according to the invention.
Figure 10 illustrates a protrusion provided with a plurality of nano-sized tips across the outer surface of the protrusion.
Figures 11a to 11c illustrate the appearance of the SiOₓC_{y} layer formed at the beginning of diamond growth in a silicon mold.
Figures 12a and 12b illustrate pyramid-shaped protrusions with a few or only one nano-sized tip portion in the apex area of the protrusion.
Figure 13 illustrates a pyramid-shaped protrusion having a thicker diamond layer on the apex area than on the side planes of the protrusion.

### Detailed description of the invention

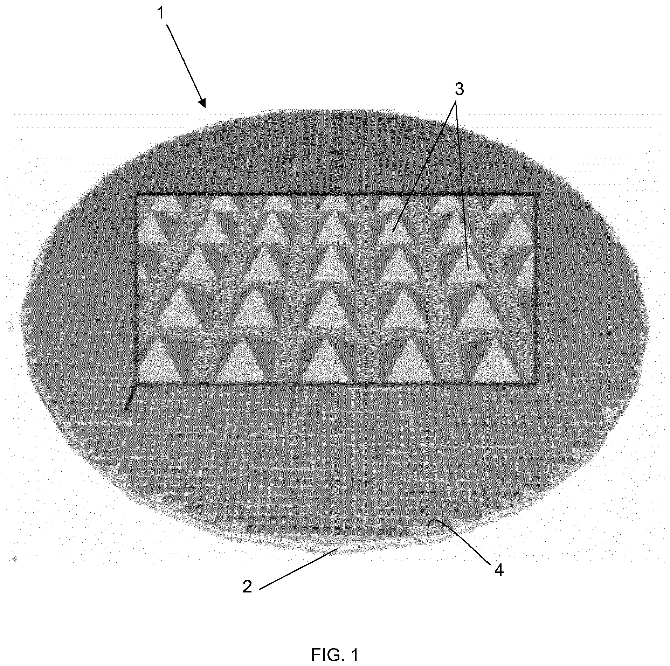

A first embodiment of a reconditioning wafer 1 according to the invention is illustrated in Figure 1. The middle image shows a detail of a portion of the wafer's upper surface. The reconditioning wafer comprises a carrier wafer 2 comprising on its surface an array of regularly spaced 4-sided pyramid-shaped protrusions 3 having essentially the same dimensions and thereby the same sharpness. In this particular embodiment, a diamond layer 4 forms the outer surface of the pyramid-shaped protrusions 3 and of the planar area in between the protrusions 3. The wafer can be used for reconditioning a DLC-coated wafer stage in the manner described above, by bringing the wafer into contact with the DLC coated holding surfaces of the wafer stage, with the diamond coated protrusions contacting the DLC coating, and applying a pressure so that the protrusions are pressed into the DLC coating.

The use of a reconditioning wafer according to the invention has the advantage that the protrusions are regularly spaced and have essentially equal height and sharpness, thus enabling the reconditioning of the DLC coating in a well-defined and repeatable manner. Other shapes of the protrusions are possible, as will be described further in this text. The dimensions of the protrusions (the ground plane and height of the pyramids for example) can be designed within a wide range, from a few tenths of a nanometre to the order of micrometres. Also the pitch of the array can be controlled within these orders of magnitude. The diamond layer may consist of doped or undoped diamond, but the layer 4 is not limited to a diamond layer. Any material that is suitable for making indentations in a support surface such as in the DLC coating of the wafer stage, can be used in the invention. The material of layer 4 is therefore generally referred to as the 'indentation material'. This material is preferably different from the material or materials of the carrier wafer 2. Other possible indentation materials are : carbides, oxides or nitrides. Metals and metal alloys are other alternatives, even though in the particular case of reconditioning a holding stage of a stepper for a silicon wafer, metals are generally not allowed as they are regarded as contaminants. Metal or metal alloys may however be applicable for the reconditioning of wafer stages used with other wafer types and processing tools. The indentation material does not necessarily need to be present on the whole outer surface of the protrusions 3. In any of the embodiments, the protrusions comprise an apex area of which the outer end forms a tip suitable for making an indentation. At least the tip of the protrusions is formed of the indentation material.

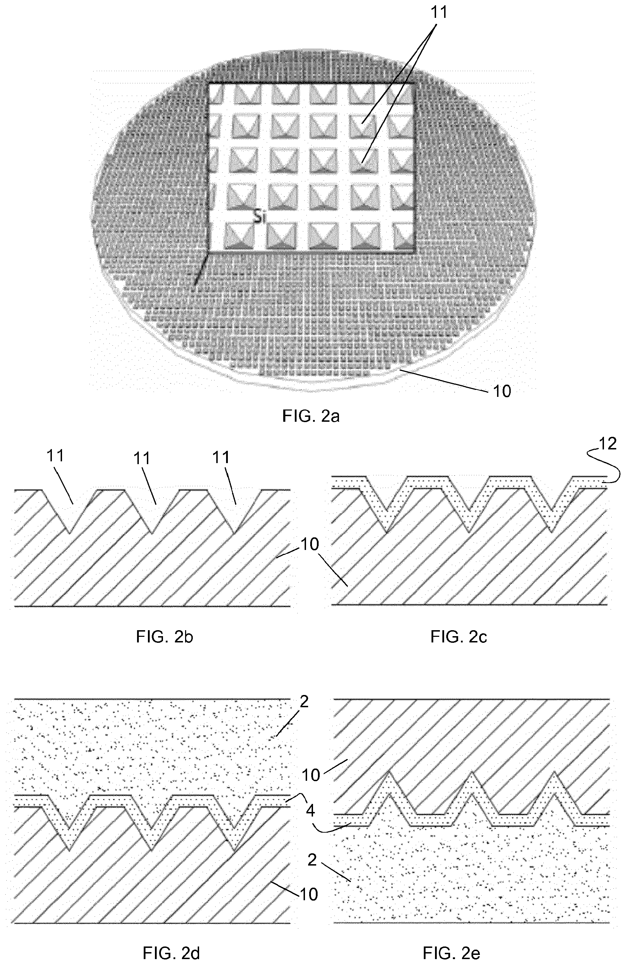

A preferred manufacturing process for producing the wafer of Figure 1 is described hereafter. The process applies a molding technique known as such from the production of diamond tips for scanning probe microscopy (SPM) applications, but now applied on a wafer scale. A mold substrate is provided, for example a (100) Si wafer. A hardmask is deposited on the wafer and patterned by lithography and etching. The hardmask may be a layer of SiO₂ or SiO₃N₄. The patterning step opens up an array of regularly spaced squares or circles in the mask, i.e. exposing square or round areas of the underlying Si. This is followed by an anisotropic wet etching process, e.g. using KOH as the etchant. The anisotropic etch follows the crystal planes of the (100) Si, resulting in the formation of inverted pyramid-shaped molds in the Si surface. After stripping of the hardmask, the Si mold wafer 10 as shown in Figure 2a is obtained. The Siwafer comprises a regular array of inverted pyramid-shaped molds 11 as shown in the detail image in Figure 2a. Each mold comprises slanted sidewalls and an apex area at the bottom. In the embodiment shown, the array is present on the entire wafer surface. Alternatively, the array may cover just a portion of the surface, or several arrays may be distributed on the surface.

Figure 2b shows a local cross-section through the centre of three of the molds 11. Diamond seed particles (not shown) are deposited on the mold wafer 10, i.e. in the molds 11 and on the Si-surface in between the molds 11. As known in the art, for example from the fabrication of SPM probes, the deposition of the nano-sized seed particles may be done by immersion seeding, wherein the wafer 10 including the molds 11 is immersed into a colloidal solution of the particles in a solvent such as ethanol or H₂O. The potential of these diamond nanoparticles is adjusted to be opposite of the potential of the Si mold wafer 10 which results into attraction and finally deposition of these diamond nanoparticles onto the Si surface.

As illustrated in Figure 2c, this is followed by the deposition of a diamond layer 4 by chemical vapour deposition (CVD), for example hot filament CVD (HFCVD). The diamond layer 4 is formed by heteroepitaxial growth starting from the seed particles, eventually forming a diamond layer 4 inside the molds 11 and on the Si-surface in between the molds 11. The diamond layer 4 may fill up the molds 11 completely or form a layer on the slanted sidewalls of the molds (as is the case in the drawings), depending on the size of the molds 11 and the thickness of the deposited diamond layer 4. The diamond layer 4 may have a thickness in the order of 1 micrometre. The diamond layer 4 may be doped or undoped.

As illustrated in Figure 2d, a carrier wafer 2 is then bonded to the diamond layer 4. Possibly the diamond layer 4 is first planarized by a chemical mechanical polishing (CMP) process, prior to the bonding step. The carrier 2 may be a silicon wafer. Direct bonding of the diamond layer 4 to a silicon carrier wafer 2 may be done by pressing the 2 surfaces against each other in high vacuum or ultra-high vacuum with a bonding pressure of about 30-50 MPa at about 1000 to 1100°C for 0.5 to 3 hours. Alternatively, the bonding process may involve the production of one or a stack of bonding layers (not shown) on the diamond layer 4 and/or on the silicon carrier wafer 2. A bonding layer stack may include oxide layers, metal layers or organic layers. For example, a silicon or silicon oxide film may be deposited on the diamond layer 4 and the silicon carrier wafer 2 is then pressed against the silicon or silicon oxide surface with a bonding pressure of about 30 to 50 MPa at about 400 to 500°C for 0.5 to 3 hours. In the case shown, according to which the molds 2 are lined with the diamond layer 4, the bonding layer or layer stack may fill the remaining cavities of the molds and form a planar surface, possibly after CMP, that is subsequently bonded to the carrier 2.

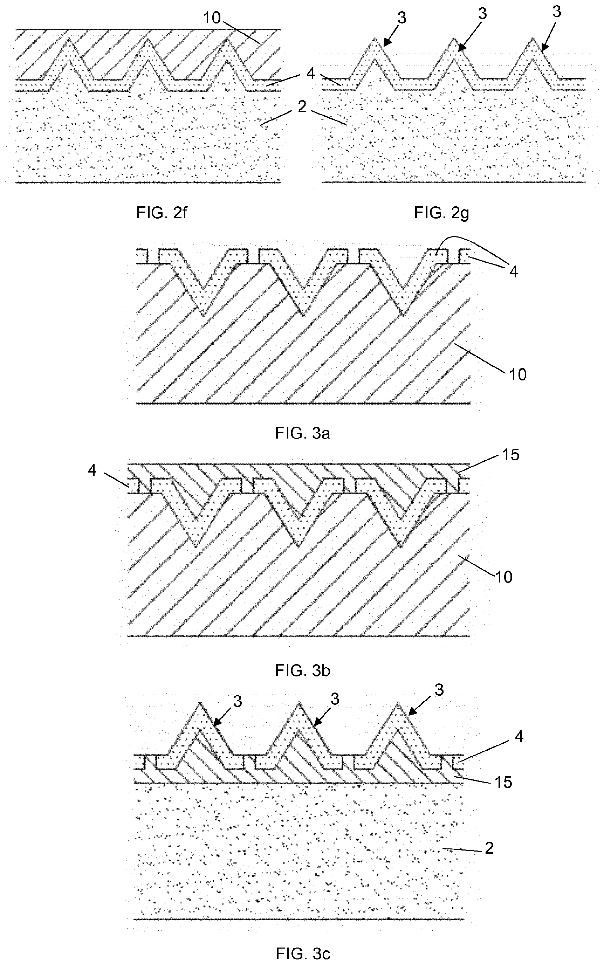

As illustrated in Figures 2e and 2f, the bonded assembly of the Si mold wafer 10 and the carrier wafer 2 is flipped and the mold wafer 10 is thinned by grinding and/or chemical mechanical polishing to a thickness in the order of a few tenths of a micrometre. The remainder of the mold wafer 10 is then removed by wet etching, e.g. using KOH as the etchant, until the diamond layer 4 is exposed, resulting in the reconditioning wafer 1 comprising the protrusions 3 as shown in Figure 2g, and illustrated in its entirety in Figure 1. The thickness of the carrier wafer 2 can be chosen in such a way that a desired contact pressure (hence diamond tip penetration depth) is achieved. This is possible as the number of diamond tips and their sharpness is exactly known which is not the case for the prior art.

The invention is not limited to the above-described embodiment and many variations and alternatives are possible. After filling the molds 11, the diamond layer 4 may be further processed by lithography and etching, as illustrated in Figure 3a for example, where after the deposition of the diamond layer 4 on the surface of the mold wafer 10, the diamond layer 4 is etched away except in the molds 11 and in an area in the immediate vicinity of the molds 11. The diamond could even be partially etched away inside the mold, leaving only a diamond layer around the apex area of the mold. A layer or layer stack 15 is then deposited, as seen in Figure 3b. This may be a silicon or silicon oxide layer deposited by CVD or sputtering for example. Alternatively and for applications where the use of a metal does not raise contamination concerns, it may be a stack of metal layers, for example a combination of Cu (about 50 nm) as seed layer for Ni electroplating, and Ni (about 5 microns). The layer or layer stack 15 fills the remaining hollow portion of the molds 11 and the areas where the diamond was etched away. The carrier wafer 2 is then bonded to the layer or layer stack 15, by a suitable stack of bonding layers, after which the mold wafer 10 is again removed by thinning and wet etching, leading to the result shown in Figure 3c. The diamond layer 4 is now a non-continuous layer, formed of individual diamond patches on and in the immediate vicinity of the pyramids 3, while the area in between the patches is formed by the layer or layer stack 15. This is one example of an embodiment wherein the indentation material forms a non-continuous layer covering at least the protrusions 3. The non-continuous layer could also be formed of multiple separate patches, each patch covering a sub-group of protrusions of the array and the surface area between the protrusions of the sub-group. A layer or layer stack 15 may then again separate the patches from each other. The embodiments having a non-continuous layer of the indentation material, in particular when the material is diamond, are advantageous in terms of the wafer's resistance to bowing. When the diamond layer is non-continuous, wafer bowing can be decreased or eliminated without requiring anti-stress coatings or other measures.

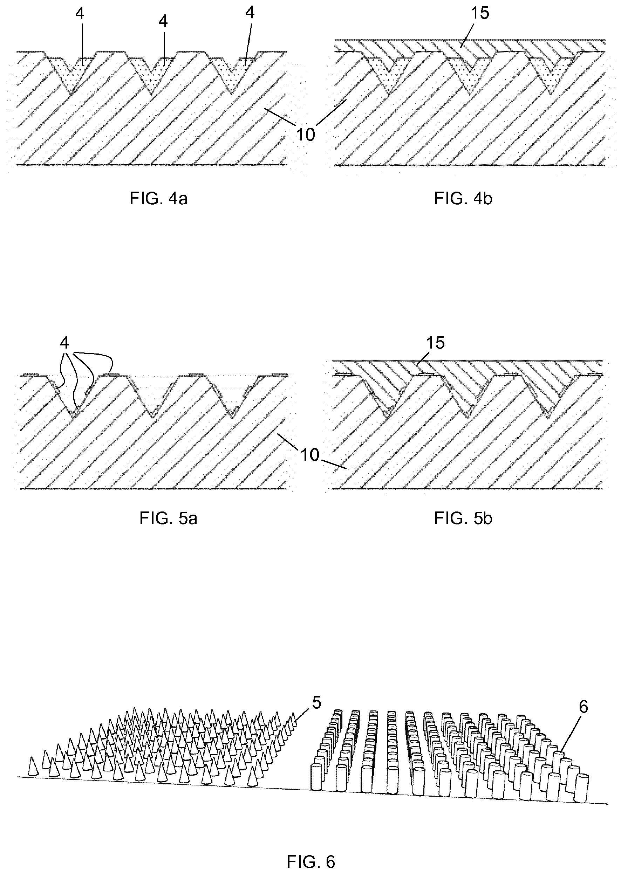

Another way of obtaining a non-continuous diamond layer is by partially filling or lining the molds 11 with the indentation material. This may be realized for example by depositing diamond seed particles only in a limited area that includes the apex area of the mold by applying a hardmask on the remainder of the mold, resulting in diamond layers as illustrated in Figure 4a. This is then followed by the deposition of a layer or layer stack 15 prior to the step of bonding to the carrier wafer 2, as illustrated in Figure 4b.

A further alternative fabrication method which falls under the term 'partially filling or lining the molds', is to apply a lower density of the seed particles than required for obtaining a closed diamond layer 4. The resulting diamond layer is a non-closed layer 4 as illustrated schematically in Figure 5a. The diamond growth is continued until at least the apex areas of the molds are covered with diamond. This is again followed by the deposition of a layer or layer stack 15 prior to the step of bonding to the carrier wafer 2, as illustrated in Figure 5b.

The protrusions 3 may have other shapes besides the four-sided pyramids illustrated in the drawings. For example, (311) Si wafers can be used for creating three-sided pyramidal structures by the same molding technique described above. (110) Si or 45° oriented (100) Si can be used to create pillar-like structures by the same molding technique.

Also, nano-cones 5 and/or nanowires 6 may be used as protrusions, as illustrated in Figure 6. These can be produced by the molding technique described above, but wherein the molds are shaped as inverted nano-cones or nano-wires. These molds are obtainable by producing a hardmask that exposes a regular array of round openings on the surface of the mold substrate, and etching the exposed material of the mold substrate by a dry (plasma) etch process. Alternatively, a blanket diamond layer of for example 1 micrometre thick may be deposited on a flat silicon wafer (i.e. without molds), and subsequently bonded to a carrier wafer as described above, after which the silicon wafer is removed (also as described above), resulting in the carrier wafer with a smooth diamond layer on its surface. The diamond layer is then patterned by first producing a lithographic mask on the diamond layer, the mask being formed of nano-sized circular mask portions at regular distances. A dry etch process, for example a plasma etch using O₂ as the plasma gas, thins or removes the diamond around the circular areas, thereby creating a regular array of nano-cones or nano-wires. The circular mask portions will in the end be consumed by the etch process, but much slower than the diamond layer, hence the formation of cones or wires. The shape of the resulting diamond protrusions is a cone for shorter etch times and becomes more pillar-shaped as the etch time is longer, due to the slight isotropy of the oxygen-based plasma etch.

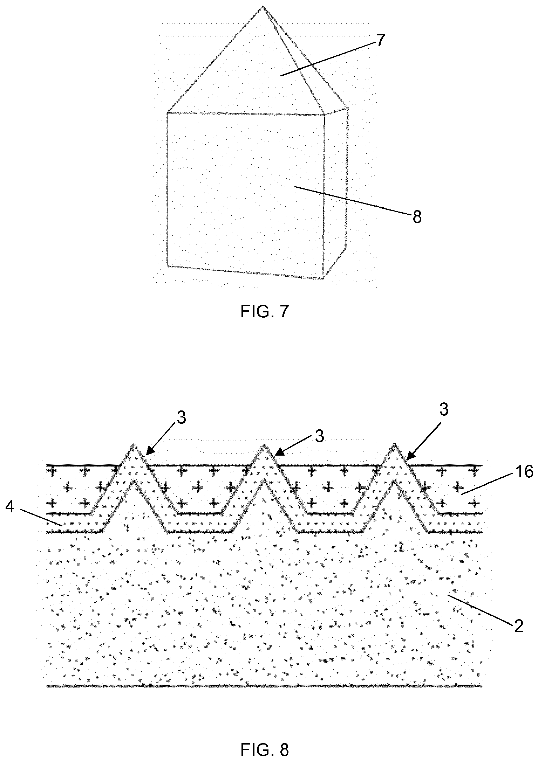

The protrusions may also have the form of a pyramid 7 on a pedestal 8 as illustrated in Figure 7. This may be realized by the molding technique described above for pyramid-shaped protrusions, including the use of a hardmask that defines an array of square openings, but wherein before the anisotropic etch process, a dry isotropic etch is done in the square areas defined by the hardmask. The dry etch results in the formation of pillar-shaped molds in the mold substrate. This is then followed by the anisotropic KOH-based etch, which forms pyramid-shaped molds at the bottom of the pillar-shaped molds, resulting in molds having the inverted shape of the protrusion shown in Figure 7. Preferably a selective oxidation and patterning step is applied after the dry etch to protect the sidewalls from etch attack during anisotropic etching.

Another possible shape for the protrusions is a pedestal in the form of a pillar with a circular cross section and with a cone-shaped element on top of the pillar and essentially concentric with the pillar, the ground plane of the cone-shaped element having the same diameter as the cross-section of the pillar. This may be obtained by depositing a blanket diamond layer of for example 1 micrometre thick on a flat silicon wafer (i.e. without molds), and subsequently bonding the diamond to a carrier wafer as described above, after which the silicon wafer is removed (also as described above), resulting in the carrier wafer with a smooth diamond layer on its surface. A hardmask is then applied in the form of a regular array of circular masked areas. This is followed by a first dry etching step with a pronounced anisotropic etching defining the pillar shapes and a second dry etching step with a pronounced isotropic underetching of the circular mask areas defining the nano-cones.

A truncated pyramid-shape is equally possible, which may be produced by creating molds with truncated bottoms, by adjusting the dimensions of the openings created in the hardmask referred to above, prior to the anisotropic etch process for producing the molds.

As already illustrated in Figure 6, a reconditioning wafer according to the invention may comprise a plurality of arrays of regularly spaced protrusions, each array consisting of protrusions of the same shape and dimensions, but wherein the arrays are different one from the other, in terms of one or more characteristics of the protrusions, including the shape, the dimensions and the spacing. This allows to use a single reconditioning wafer for performing reconditioning operations with different requirements.

According to an embodiment, an additional layer or layer stack may be deposited on the side of the reconditioning wafer comprising the protrusions.

Figure 8 illustrates an embodiment wherein an organic layer 16 is formed on the surface of the carrier wafer 2, and wherein the thickness of the organic layer 16 does not exceed the height of the protrusions 3, so that the tips of the protrusions 3 stick out of the organic layer 16. The layer 16 may for example be formed of a silicon gel or PDMS (polydimethylsiloxane). The layer 16 facilitates the conditioning operation as it acts as a penetration stop. At the same time, the layer 16 may serve as a debris clean-up layer, as debris present on the reconditioned wafer support surfaces may be picked up by adhering to the layer 16. The layer 16 may be produced by spin-on coating or vapor phase deposition.

According to an embodiment, the reconditioning wafer comprises one or more arrays of protrusions as described above, and further comprises at least one area comprising a debris cleaning layer as described in the previous paragraph but without protrusions therein. This embodiment allows to perform a reconditioning operation followed by a debris cleaning step, using the same reconditioning wafer.

A reconditioning wafer according to the invention can be produced in a variety of sizes, ranging from about 2 cm in diameter to 300 mm. Pyramid-shaped protrusions with increased sharpness may be produced by subjecting the mold substrate 10, after the creation of the molds 11 (as in Figures 2a and 2b), to an oxidation step at low temperature, which has the effect of sharpening the bottom of the molds 11, as described for example in document "Low temperature thermal oxidation sharpening of microcast tips", Journal of Vacuum Science & Technology B: Microelectronics and Nanometer Structures Processing, Measurement, and Phenomena 10, 2307 (1992).

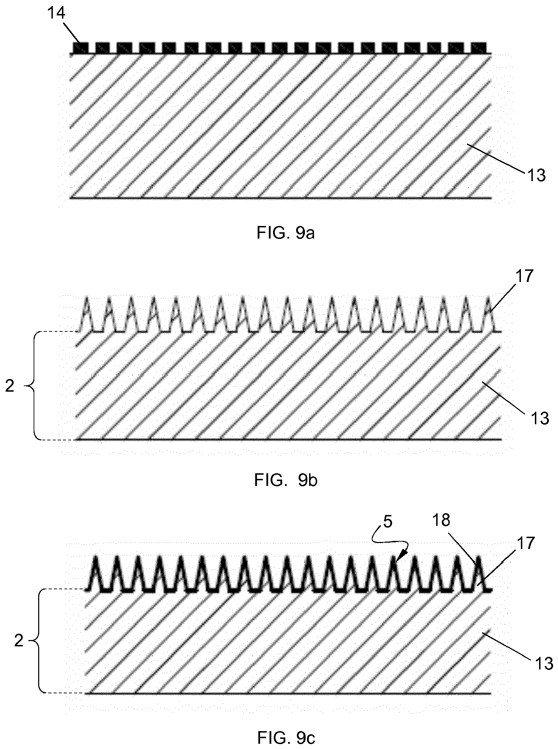

An alternative method for producing a reconditioning wafer according to the invention is illustrated in Figures 9a to 9c. This method does not require molding nor bonding to a carrier wafer. A monocrystalline silicon wafer 13 (or a wafer having a monocrystalline Si layer 13 on its surface) is provided and a lithographic mask is produced on the upper surface of the wafer. The mask is formed as a regular array of islands 14 of masking material. The islands may have a circular cross-section. Then the wafer 13 is etched by a plasma etch process, resulting in the creation of a regular array of silicon cones 17 on the surface of the remaining bulk portion 2 of the silicon wafer. In the terminology of the appended claims, this bulk portion 2 is now the carrier substrate. When the etch time is longer, the shape will become more pillar-like due to the slight isotropic character of the dry etch process. A diamond layer 18 is then applied conformally on the array of Si cones, resulting in an array of diamond-coated cone-shaped protrusions 5 suitable for reconditioning a wafer stage. Optionally, the diamond layer 18 could be patterned by lithography and etching to remove the diamond in between the cones and maintain the diamond at least on the apex area of the cones, to thereby form separate diamond coatings on the respective Si cones, leading to the same advantages in terms of wafer bowing as the embodiment shown in Figures 3c, 4b and 5b.

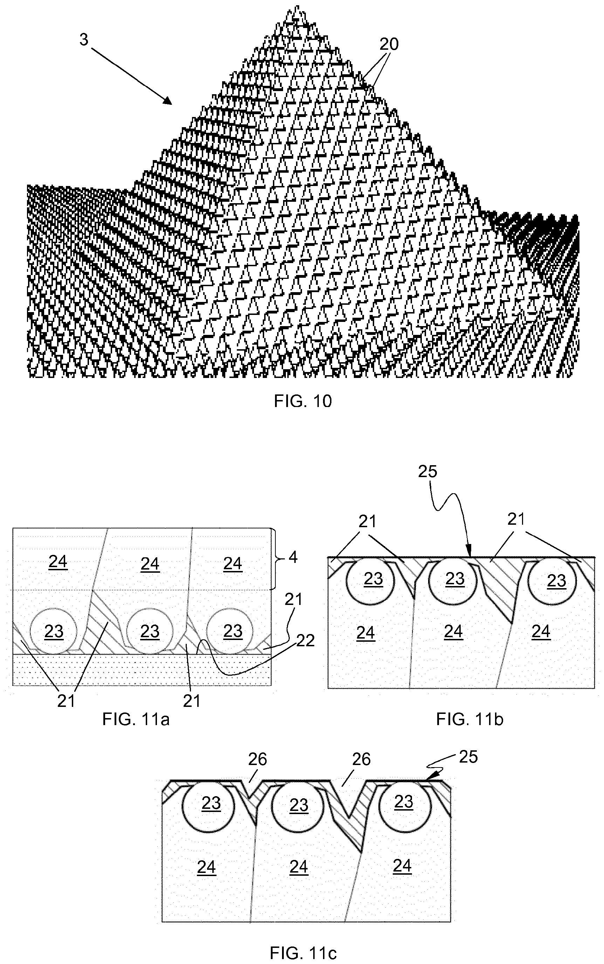

According to an embodiment, one or more nano-sized tips are present on the outer surface of the protrusions. An example is illustrated in Figure 10, where a pyramid-shaped diamond protrusion 3 is shown that is covered by a plurality of nano-sized diamond tips 20, which also cover the diamond layer around the protrusion 3. The nano-sized tips 20 are shown as a regular array but in reality the tips are distributed more randomly and more closely spaced on the outer surface of the protrusion 3. The dimensions of the nanotips are in the order of nanometres, for example a height of about 50 to 100nm. The radius of the apex area of the nanotips ranges from less than 1 nm up to a few nanometres. The nanotips are small with respect to the dimensions of the protrusions 3 as such. This embodiment is therefore applicable only when the dimensions of the protrusions are considerably larger than the order of magnitude of the nanotips. When the nanotips are present, the shape and the dimensions of the protrusions may be defined taking into account an average height of the nanotips which can be derived from SEM images or the like.

The formation of such nano-tips 20 may be realized by a self-aligned dry etching process described hereafter in the case of diamond or diamond coated pyramid-shaped protrusions obtained by the molding technique. The diamond seed particles referred to above can act as masks for the production of the nanotips 20, provided that at least a portion of these particles are non-doped diamond particles. The density of the seed particles when deposited in the mold may be in accordance with existing methods for producing SPM tips, for example between 1E10/cm² and 5E10/cm². The density may however be controlled within a larger range of 1E9/cm² and 1E11/cm² by adjusting the seeding dispersion chemistry, the particle and substrate potential and the seeding time. The applied density must be such that it enables the growth of a closed (i.e. fully coalesced) diamond layer in the mold. According to an embodiment, the particles consist of a mixture of non-doped diamond particles and doped diamond particles, deposited at any of the above-described densities. Both the doped and non-doped particles enable the growth of a closed diamond layer, but only the non-doped particles will act later on as masks for the creation of the nano-tips. The diameter of the individual particles is typically 3 to 5 nm but they often cluster to aggregates leading to a size distribution of typically 5 to 25 nm.

In order to produce the nanotips 20, the diamond layer 4 deposited in the molds 11 as shown in Figure 2c is necessarily a doped diamond layer. The dopant may be boron. After this, the above-described method steps are completed and the reconditioning wafer 1 shown in Figure 2g is obtained. The wafer 1 is then subjected to a plasma etch procedure. This may be Reactive Ion Etching (RIE) or Inductive Coupled Plasma (ICP) etching, configured so that the non-doped diamond seed particles have a lower etch rate than the doped diamond of the protrusions 3. This means that the particles are etched slower than the doped diamond, i.e. the particles act as an etch mask for the etching of the doped diamond. A suitable etch process having this effect is a plasma etch using O₂ as the plasma gas, already referred to above, and well known in the art. Furthermore, at the beginning of the process of growing diamond in the Si molds 11, a thin (typically 1-5 nm thick) silicon oxycarbide layer is spontaneously formed with a non-uniform thickness. Silicon oxycarbide is the compound SiOₓC_{y}, with x<2 and y>0. Like the non-doped seed particles, the SiOₓC_{y} layer is etched slower by an O₂ plasma etch than the doped diamond, i.e. the SiOₓC_{y} also acts as an etch mask.

As illustrated in Figure 11a, the SiOₓC_{y} layer 21 is formed on the mold surface 22, in the spaces between adjacent seed particles 23, and grows thicker until the space in between the growing doped diamond islands 24 is closed and a fully coalesced diamond film 4 is formed. The outer surface of the protrusion 3 after the removal of the mold substrate 10 is shown in Figure 11b. The SiOₓC_{y} layer 21 together with the seed particles 23 form a layer 25 of irregular thickness, visualized by the bold lines in Figure 11b. When the array of protrusions 3 is subjected to O₂-plasma etching, the SiOₓC_{y} portions 21 and the nanoparticles 23 are slowly etched away, until parts of the doped diamond layer 4 become exposed. This happens locally due to the irregularity of the thickness of layer 25. At these locations, doped diamond is etched at a higher speed than the SiOₓC_{y} 21 and the seed particles 23. As the O₂ etch process continues, sharp nano-sized doped diamond tip portions 20, also referred to as nanotips, are formed in the diamond layer 4, resulting in a 'hedgehog' tip structure illustrated in Figure 10.

According to another etch procedure capable of obtaining the structure shown in Figure 10, the protrusions 3 are first subjected to a short plasma etch using SF₆ or a mixture of SF₆ and O₂ as the plasma gas, for example for about 20 s. This short 'flash' etch creates craters 26 in the SiOₓC_{y} layer 21, as illustrated in Figure 11c. This step is followed by an O₂ plasma etch as described above. The prior removal of a portion of the SiOₓC_{y} leads to a quicker exposure of the doped diamond layer 12, so that the 'hedgehog' structure of Figure 10 is obtained in an overall shorter timespan.

Apart from the SiOₓC_{y} layer 21 and the seed particles 23 acting as an etch mask, a third masking effect may occur during the plasma etch procedure itself. The energy of the plasma may release particles from materials inside the etch chamber and/or from layers formed of other materials surrounding the diamond protrusions 3, as in the case of the embodiment of Figure 3c for example, wherein the protrusions 3 are surrounded by a metal layer 15, for example a Ni layer. Ni-particles are released by sputtering under the influence of the ion bombardment generated by O₂, SF₆ or SF₆/O plasma. Also because of the bombardment with ions from the plasma, the pyramids 3 gain static charge, resulting in an electric field, which attracts the Ni-particles. The Ni-particles are thereby deposited on the pyramids, but Ni is essentially not etched by SF₆ nor by O₂ plasma, so that the Ni-particles are also acting as etch masks in the same way as the seed particles 23 and SiOₓC_{y} layer portions 21. The field is stronger where the surface is sharper, i.e. at the pyramid plane edges and mostly at the apex, so the concentration of Ni-particles is higher in these areas, which may be exploited for the production of specific tip structures (see further). When the dry etch is stopped sufficiently early, i.e. before etching away the nanotips 20 themselves, the three above-described masking effects, the SiOₓC_{y} 21, the seed particles 23 and the Ni-particles have the combined effect of producing the 'hedgehog' structure illustrated in Figure 10. The SiOₓC_{y} and seed particle effects are more important at the start of the etch process, and may be the dominant processes in the case of thin diamond layers 12, e.g. about 100nm. For thicker diamond layers, e.g. 1 micrometre, or full diamond protrusions 3, all three effects contribute to the formation of the nanotips 20 and the Ni-sputtering effect will become dominant after the SiOₓC_{y} and the seed particles have been etched away.

The etch procedures described above are stopped when the nanotips 20 have obtained a given shape and aspect ratio. In the case of the above-described O₂ plasma etch of a diamond tip, the O₂-etch duration defines the shape of the nanotips. At first, the nanotips are cone-shaped pillars, as illustrated in Figure 10. As the etch process is applied longer, the nanotips become more needle shaped, due to a slight isotropy of the dry etch process. The etch time can thus be controlled to obtain a given shape. When the etch process is stopped, portions of the seed particles and/or the SiOₓC_{y} layer and/or of the sputtered particles may still be present on the nanotips 20. For some applications, these remnants of the etch mask are not a problem and they may remain. Otherwise, a slight oxygen overetch may burn away these remnants. The etch process is self-aligned, and requires no lithographic mask other than the particles, SiOₓC_{y} layer or other contributors to the mask layer referred to above.

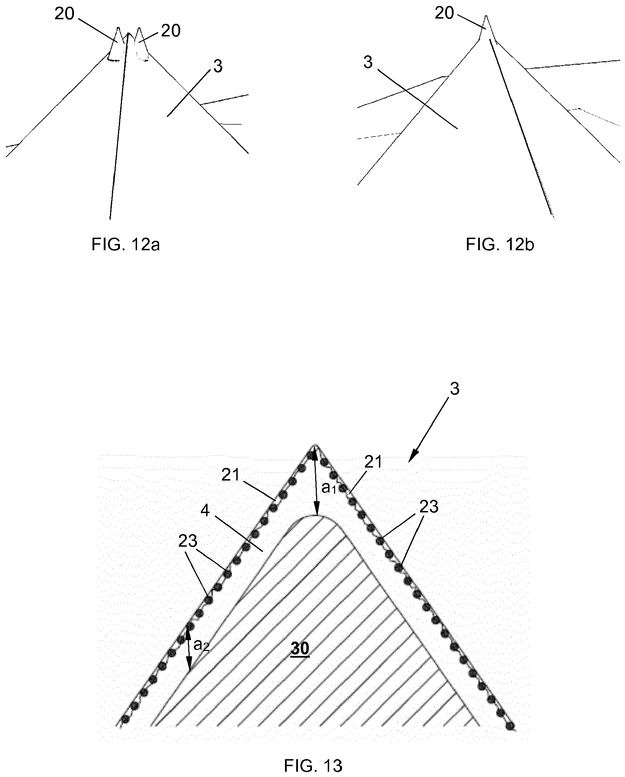

According to an embodiment, the dry etch process is continued until the nanotips 20 are etched away on the side planes of the pyramids. However, one or more nanotips 20 are nevertheless formed on the apex area of the pyramids, as schematically illustrated in Figures 12a and 12b. This structure may be obtained by exploiting one or more effects, possibly occurring simultaneously. In the case of the diamond-coated protrusions/silicon molds/Ni layer setup described above, the sputtering of Ni particles during the etch process is one effect that contributes to this type of structure. As stated above, the electric field generated by the ion bombardment is stronger where the surface is sharper, i.e. at the pyramid plane edges and mostly at the apex. The field attracts the Ni particles, so there are more etch mask particles at the apex than on the sidewalls. As a consequence, while the diamond layers 4 on the sidewalls of the protrusions are completely etched away, one or more sharp diamond tips 20 remain on the apex regions. After the etch procedure, the protrusions 3 are therefore entirely formed by Ni, except for the sharp diamond tips 20 in the apex areas.

A second contributor to realizing the latter embodiment is the fact that the diamond layer 4 may be thicker near the apex region compared to on the side planes of the pyramids. This is illustrated in Figure 13, which shows a cross-section of a diamond coated pyramid-shaped protrusion 3, having a Ni core 30 and a doped diamond layer 4. Figure 13 also shows schematically the presence of the non-doped diamond seed particles 23 and of the SiOₓC_{y} layer 21. It is seen that the thickness of the diamond layer 4, as measured in the direction perpendicular to the ground plane of the pyramid, is larger at the apex region (thickness a₁) than on the sides of the pyramid (thickness a₂). This may be a consequence of the deposition process applied for forming the diamond layer. When the dry etching process is continued until the diamond layer 4 is removed from the sides of the pyramid, a substantial diamond thickness remains on the apex area, due to the difference in thickness between a₁ and a₂. This results in the appearance of one or more nanotips 20 at the apex region only, as illustrated in Figures 12a and 12b. The number of nanotips appearing depends on the exact distribution of the particles near the apex region. The difference between the thicknesses a₁ and a₂ is not always occurring or may not be sufficient to obtain the above-described effect. It may depend on the average thickness of the diamond layer 4, and/or on specific parameters applied when producing this layer.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A reconditioning wafer (1) suitable for making indentations in a wafer support surface of a wafer holding stage in a semiconductor manufacturing or treatment tool, the reconditioning wafer (1) comprising a carrier substrate (2) and on a planar surface of the carrier substrate, at least one 2-dimensional array of regularly spaced protrusions (3,5,6,7+8), the protrusions having essentially the same shape and the same dimensions and wherein at least the tip of the protrusions (3,5,6,7+8) is formed of a material, hereafter referred to as the indentation material, that is suitable for making said indentations.

2. The reconditioning wafer (1) according to claim 1, wherein the indentation material is chosen from the group consisting of undoped diamond, doped diamond, a carbide, an oxide, a nitride, a metal alloy, a metal.

3. The reconditioning wafer (1) according to claim 1 or 2, wherein a continuous layer (4) of the indentation material conformally covers the entire array of protrusions, including the surface of the carrier substrate (2) in between the protrusions (3,5,6,7+8).

4. The reconditioning wafer (1) according to claim 1 or 2, wherein the indentation material is present in the form of a non-continuous layer that is present at least on the tip of the protrusions.

5. The reconditioning wafer (1) according to any one of the preceding claims, wherein the shape of the protrusions is chosen from the group consisting of: a four-sided pyramid (3), a three-sided pyramid, a truncated pyramid, a cone (5), a pillar (6), a pyramid (7) or a cone on top of a pedestal (8).

6. The reconditioning wafer (1) according to any one of the preceding claims wherein the protrusions comprise one or more nano-sized tip portions (20) on their outer surface, the tip portions being considerably smaller than the protrusions.

7. The reconditioning wafer (1) according to any one of the preceding claims, wherein a plurality of arrays of protrusions are arranged on the surface of the carrier substrate (2), and wherein the protrusions of at least one array are different from the protrusions of the other arrays.

8. The reconditioning wafer (1) according to any one of the preceding claims, comprising an additional layer (16) that covers at least an area of the carrier substrate (2) that corresponds to the array of protrusions, and wherein the thickness of the additional layer is lower than the height of the protrusions, so that only the tip of the protrusions sticks out from the surface of the additional layer (16).

9. The reconditioning wafer (1) according to claim 8, wherein the additional layer (16) is formed of a material that is suitable for picking up debris from the support surface of the wafer holding stage.

10. The reconditioning wafer (1) according to any one of the preceding claims, wherein the planar surface of the carrier substrate (2) comprises, in an area apart from the at least one array of protrusions, a layer formed of a material that is suitable for picking up debris from the support surface of the wafer holding stage.

11. A method for producing a reconditioning wafer (1) in accordance with any one of the preceding claims, comprising the steps of:
- Providing a mold substrate (10),
- By lithography and etching, producing one or more two dimensional arrays of regularly spaced molds (11) in the mold substrate, the molds having essentially the same shape and dimensions, the molds having slanted sidewalls and an apex area,
- Depositing a layer of the indentation material on the mold substrate, thereby at least partially filling or lining the molds (11) with the indentation material, so that the indentation material is deposited at least on the bottom of the molds (11),
- Bonding the mold substrate to a carrier substrate (2), by bonding the layer of indentation material or one or more further layers deposited on top of the layer of indentation material to said carrier substrate (2),
- Removing the mold substrate (10) to reveal the outer surfaces of the protrusions (3,5,6,7+8).

12. The method according to claim 11, wherein :
- a mask layer comprising nano-sized mask particles is formed on the protrusions, the nano-sized mask particles being deposited in the molds (11) prior to filling the molds, and/or deposited on the protrusions after removing the mold substrate,
- The protrusions are subjected to a plasma etch procedure, wherein the mask layer acts as an etch mask for the etching of the indentation material, and wherein the etch procedure and the etch mask are configured to produce one or more nano-sized tip portions (20) formed of the indentation material, the one or more tip portions being considerably smaller than the protrusions formed after removing the mold substrate.

13. The method according to claim 12, wherein the protrusions are pyramid-shaped and wherein at the end of the plasma etch procedure, one or more nano-sized tip portions (20) are present on the apex area of the protrusions and no tip portions are present on the side planes of the protrusions, through one or a combination of the following effects :
- a higher concentration of masking particles is deposited on the apex area than on the side planes, during the plasma etch procedure,
- the protrusions comprise a core (30) and on said core a layer (4) of the indentation material, and the thickness of said layer is higher on the apex area than one the side planes, so that at the end of the plasma etch procedure, the indentation material is removed from the side planes.

14. A method for producing a reconditioning wafer (1) in accordance with any one of claims 1 to 10, comprising the steps of:
- providing a substrate (13) having a planar upper surface,
- producing a mask layer on the planar upper surface,
- patterning the mask layer to form a regular array of islands (14) of masking material,
- subjecting the substrate to a dry etch process to thereby create cone-shaped or pillar-shaped protrusions (17) in the substrate at the locations of the islands (14),
- coating at least the upper part of the protrusions (17) with a layer (18) of the indentation material.

15. A method for producing a reconditioning wafer (1) in accordance with any one of claims 1 to 10, comprising the steps of:
- providing a first substrate having a planar upper surface,
- depositing a layer of the indentation material on the planar upper surface and thereafter bonding the substrate to a carrier substrate, by bonding the layer of indentation material or one or more further layers deposited on top of the layer of indentation material to said carrier substrate,
- removing the first substrate, to obtain the carrier substrate with the layer of indentation material bonded thereto,
- producing a mask layer on the layer of indentation material and patterning the mask layer to form a regular array of islands of masking material,
- subjecting the layer of indentation material to a dry etch process to thereby create cone-shaped or pillar-shaped protrusions (5,6) formed of the indentation material at the locations of the islands.
